Europäisches Patentamt

European Patent Office

Office européen des brevets

(11) Publication number: **0 153 098**
**B1**

# EUROPEAN PATENT SPECIFICATION

(45) Date of publication of patent specification: 23.05.90

(51) Int. Cl.⁵: **H 05 K 1/05**

(21) Application number: 85300825.8

(22) Date of filing: 07.02.85

(54) **Copper foil laminate for use as a base plate or substrate for electronic devices.**

(30) Priority: 14.02.84 JP 25892/84

(43) Date of publication of application:
28.08.85 Bulletin 85/35

(45) Publication of the grant of the patent:
23.05.90 Bulletin 90/21

(84) Designated Contracting States:
BE DE FR GB IT NL

(56) References cited:
DE-B-1 242 282
FR-A-2 543 394
US-A-4 288 359

(73) Proprietor: Shin-Etsu Chemical Co., Ltd.
6-1, Ohtemachi 2-chome
Chiyoda-ku Tokyo 100 (JP)

(72) Inventor: Iida, Tamaki
3-8-43, Minami-machi
Higashikurume-shi Tokyo (JP)

(74) Representative: Perry, Robert Edward et al
GILL JENNINGS & EVERY 53-64 Chancery Lane
London WC2A 1HN (GB)

## Description

The present invention relates to a copper foil laminate for use as a base plate or as a substrate plate for various kinds of electronic devices such as printed circuit boards, in which laminate high thermal conductivity is ensured.

Copper foil laminates for use as base plates or substrates of electronic devices have been under continuous improvements along with other developments in the electronic industry and the production thereof has grown to such an extent as to form an important part of the electronic component industry. In view of the rapidly increasing density of integration of integrated circuits from ICs to LSIs, the copper foil laminates used as base plates or substrates are under growing requirements to satisfy more and more severe thermal conditions and it is now desired that the laminate should have a very high thermal conductivity to provide a heat dissipative surface.

As is known, most conventional copper foil laminates for use as base plates or substrates are formed of a synthetic resin such as a phenolic resin, epoxy resin, or the like with limited resistance to heat, chemicals and water or moisture. The use of glass fibre-reinforced synthetic resin has of course contributed to the improvement of the heat resistance to some extent but such material is far from satisfactory when the copper foil laminate is desired to have a greatly increased thermal conductivity and to serve as a heat dissipative surface.

Further, conventional finished laminates have sometimes limited cleanliness on their surfaces so that the degree of bond of the parts mounted on the base plate is limited and consequently the range of the applicability of the laminates is unavoidably not broad enough.

From the document DE—B—1 242 282 there is known a substrate for use as a base for an electronic device, comprising an aluminium plate, covered with a layer of aluminium oxide, a layer of aluminium silicate or a glass, and a metal layer.

The main object of the present invention is therefore to provide a copper foil laminate which is for use as a base plate or substrate for an electronic device and which has a greatly increased thermal conductivity without the problems in the prior art copper foil laminates.

The copper foil laminate in accordance with the present invention, which has resulted from extensive investigations made by the inventor, comprises:—

(a) an aluminium plate forming a base;

(b) a layer of aluminium oxide formed on one face of the aluminium plate;

(c) a layer of amorphous silicon carbide formed on the surface of the layer of aluminium oxide; and

(d) a copper foil bonded by means of an adhesive to the surface of the layer of amorphous silicon carbide.

As is mentioned above, the base material of the copper foil laminate in accordance with the invention is a plate of aluminium which is an inexpensive metal having a high thermal conductivity and the laminate is prepared by providing the aluminium plate with three successive layers which are of aluminium oxide, amorphous silicon carbide and copper foil.

The first coating layer on the aluminium base plate is formed of aluminium oxide which can be obtained by several known methods. For example, an aluminium oxide film can be formed by conventional electrolytic anodization of the aluminium plate in an acidic electrolyte bath. Instead of the wet process of electrolytic anodization, a coating of aluminium oxide can be formed by several dry processes, including, for example CVD (chemical vapour deposition), plasma CVD, ion plating, and sputtering. The coating layer of aluminium oxide formed on the aluminium plate has a very high adhesive bonding strength to the substrate surface without danger of peeling or exfoliation and exhibits high resistance to heat, chemicals and water or moisture.

The second coating layer formed on the layer of aluminium oxide is a layer of an amorphous silicon carbide. Such an amorphous silicon carbide is known in the art to be produced by several methods using, for example, a monosilane compound and a carbon-containing compound as a combination of the starting materials in CVD, plasma CVD, ion plating, sputtering and other methods. Although any of the above mentioned methods is applicable to the formation of the layer of amorphous silicon carbide, it is highly preferred if not actually essential that the molar ratio of silicon to carbon in the amorphous silicon carbide should be in the range from 1:2 to 1:9 and the layer of amorphous silicon carbide should preferably have an electric volume resistivity of at least $10^{12}$ ohm·cm. In this regard, the volume resistivity of crystalline silicon carbides is too low so that crystalline silicon carbide cannot be used as a substitute for amorphous silicon carbide in the laminate in accordance with the present invention.

The thickness of each of the coating layers of the aluminium oxide and the amorphous silicon carbide should be determined in consideration of the required thermal conductivity of the resultant laminate and other requirements while the layer of aluminium oxide should preferably have a thickness in the range from 20 to 60 µm and the layer of the amorphous silicon carbide should preferably have a thickness in the range from 5 to 20 µm. The coating treatments to form these coating layers should preferably be performed at a relatively low temperature of 400°C or below in consideration of the difference in the thermal expansion coefficients between the layers or between the coating layers and the aluminium substrate.

The aluminium substrate plate thus successively provided with the coating layers consisting of an aluminium oxide layer and an amorphous silicon carbide layer is further overlaid with a copper foil which is adhesively bonded to the surface of the amorphous silicon carbide layer by use of a suitable adhesive such as an epoxy resin-based adhesive to give a finished copper foil laminate for use as a base plate having a good thermal conductivity and excellent resistance against chemicals and water or moisture.

In distinction from conventional copper foil laminated base plates, the copper foil laminate in accordance with the invention having the above described layered structure can exhibit good heat dissipation by itself with a high thermal conductivity in addition to the advantages that the laminate as finished has a high cleanliness on its surface with a very small number of pinholes.

The invention will now be described in greater detail with reference to the following Examples.

Example 1

An aluminium plate having a thickness of 0.7 mm was coated with an aluminium oxide layer having a thickness of 10 μm by the method of ion plating Thereafter, a layer of an amorphous silicon carbide having a thickness of 10 μm was formed on the aluminium oxide layer by the method of plasma CVD using tetramethyldisilane as the reactant gas diluted with hydrogen gas as a carrier and introduced into the plasma chamber kept at a pressure of about 0.03 Torr with supply of a high frequency electric power to the electrodes to generate low temperature plasma of the gas. The amorphousness of the coating layer of the silicon carbide was confirmed by the X-ray diffraction Auger spectroscopy. Further, a copper foil having a thickness of 0.070 mm was adhesively bonded to the top surface of the amorphous silicon carbide layer by use of an epoxy resin-based adhesive to give a copper-foiled laminate.

The thus prepared laminate was tested for the heat resistance, chemical resistance, water resistance and burning resistance according to the procedures specified in JIS C 6480 (1965) for copper-foiled laminates for printed circuit board to give the results below. The electric insulation was evaluated by the determination of the volume resistivity according to the procedure specified in JIC C 6481 (1976).

Heat resistance: test passed at 180°C with the whole body including the epoxy resin-based adhesive.

Electric insulation: $10^{12}$ ohm·cm.

Chemical resistance: good.

Water absorption: 0% excepting the epoxy resin-based adhesive.

Burning resistance: incombustible excepting the epoxy resin-based adhesive.

These results support that this laminate satisfies the standards specified in the above mentioned JIS Specifications.

In addition, the thermal conductivity of the copper-foiled laminate was evaluated and compared with that of a laminate without the amorphous silicon carbide layer by placing a drop of molten solder alloy at 260°C having a diameter of about 5 mm on the copper foil and measuring the time taken for the decrease of the temperature of the copper foil to 30°C in an ambient condition. The results were that the time was 86 seconds in the inventive laminate and the time was 148 seconds in the comparative laminate.

Example 2

An aluminium plate having a thickness of 2.0 mm was provided with a porous coating layer of aluminium oxide having a thickness of 20 μm by the method of electrolytic anodization. Thereafter a coating layer of an amorphous silicon carbide having a thickness of 20 μm was formed on the oxide layer by the plasma CVD method in a similar manner to Example 1. The amorphousness of this silicon carbide layer was confirmed in the same manner as in Example 1. Further, a copper foil having a thickness of 0.070 mm was adhesively bonded to the layer of the amorphous silicon carbide by use of an epoxy resin-based adhesive to give a copper-foiled laminate which was tested in the same manner as in Example 1 for the evaluation as a base plate of printed circuit boards to give the results as follows.

Heat resistance: test passed at 180°C with the whole body.

Electric insulation: $10^{12}$ ohm·cm.

Chemical resistance: good.

Water absorption: 0%.

Burning resistance: incombustible excepting the epoxy resin-based adhesive.

These results support that this laminate satisfies the standards specified in the above mentioned JIS Specifications.

**Claims**

1. A copper foil laminate for use as a base plate or substrate for an electronic device, the laminate comprising:—

(a) an aluminium plate forming a base;

(b) a layer of aluminium oxide formed on one face of the aluminium plate;

(c) a layer of amorphous silicon carbide formed on the surface of the layer of aluminium oxide; and

(d) a copper foil bonded by means of an adhesive to the surface of the layer of amorphous silicon carbide.

2. A copper foil laminate according to Claim 1, wherein the thickness of the layer of aluminium oxide is in the range of from 20 to 60 μ.

3. A copper foil laminate according to Claim 1 or Claim 2, wherein the thickness of the layer of amorphous silicon carbide is in the range of from 5 to 20 μm.

4. A copper foil laminate according to any one of Claims 1 to 3, wherein the molar ratio of silicon to carbon in the amorphous silicon carbide is in the range of from 1:2 to 1:9.

**Patentansprüche**

1. Kupferfolienschichtstoff zur Verwendung als Grundplatte oder Träger für eine elektronische Vorrichtung, die

(a) eine eine Grundplatte bildende Aluminiumplatte,

(b) eine auf einer der Seiten der Aluminiumplatte gebildete Schicht aus Aluminiumoxid,

(c) eine auf der Oberfläche der Aluminiumoxidschicht gebildete Schicht aus amorphem Siliciumcarbid und

(d) eine Kupferfolie, die mittels eines Klebstoffes mit der Oberfläche der Schicht aus amorphem Siliciumcarbid verbunden ist, umfaßt.

2. Kupferfolienschichtstoff nach Anspruch 1, worin die Dicke der Aluminiumoxidschicht im Bereich von 20 bis 60 μm liegt.

3. Kupferfolienschichtstoff nach Anspruch 1 oder 2, worin die Dicke der Schicht aus amorphem Siliciumcarbid im Bereich von 5 bis 20 μm liegt.

4. Kupferfolienschichtstoff nach irgendeinem der Ansprüche 1 bis 3, worin das Mol-Verhältnis von Silicium zu Kohlenstoff im amorphen Silicumcarbid im Bereich von 1:2 bis 1:9 liegt.

**Revendications**

1. Stratifié à feuille de cuivre utilisable comme plaque de base ou comme substrat pour un dispositif électronique, le stratifié comprenant:

(a) une plaque d'aluminium formant une base;

(b) une couche d'oxyde d'aluminium formée sur un côté de la plaque d'aluminium;

(c) une couche de carbure de silicium amorphe formée sur la surface de la couche d'oxyde d'aluminium; et

(d) une feuille de cuivre fixée à l'aide d'un adhésif sur la surface de la couche de carbure de silicium amorphe.

2. Statifié à feuille de cuivre selon la revendication 1, dans lequel l'épaisseur de la couche d'oxyde d'aluminium est comprise dans la gamme de 20 à 60 μm.

3. Stratifié à feuille de cuivre selon la revendication 1 ou la revendication 2, dans lequel l'épaisseur de la couche de carbure de silicium amorphre est comprise dans le gamme de 5 à 20 μm.

4. Stratifiée à feuille de cuivre selon l'une des revendications 1 à 3, dans lequel le rapport molaire du silicium au carbone dans le carbure de silicium amorphe est compris dans la gamme de 1:2 à 1:9.